# EUROPÄISCHE PATENTSCHRIFT

(11) **EP 0 868 780 B1**
(45) Veröffentlichungstag und Bekanntmachung des Hinweises auf die Patenterteilung: **25.08.1999**
(21) Anmeldenummer: 96946082.3
(22) Anmeldetag: 16.12.1996
(51) Int. Cl.: H03H 9/145, H03H 9/64

(54) **MIT AKUSTISCHEN OBERFLÄCHENWELLEN ARBEITENDES FILTER - OFW-FILTER**
FILTER OPERATING WITH ACOUSTIC SURFACE WAVES (SW FILTER)
FILTRE FONCTIONNANT AVEC LES ONDES DE SURFACE ACOUSTIQUES

(30) Priorität: 19.12.1995 DE 19547470
(43) Veröffentlichungstag der Anmeldung: 07.10.1998
(73) Patentinhaber: SIEMENS MATSUSHITA COMPONENTS GmbH & CO. KG, 81541 München (DE)
(72) Erfinder: BAIER, Thomas, D-81539 München (DE); MACHUI, Jürgen, D-80809 München (DE); SCHROPP, Isidor, D-85119 Ernsgaden (DE); MÜLLER, Günter, D-81737 München (DE)
(74) Vertreter: Epping, Wilhelm, Dr.-Ing.
(86) Internationale Anmeldenummer: DE9602414
(87) Internationale Veröffentlichungsnummer: WO9723040

(56) Entgegenhaltungen:
- DE-A- 3 942 140
- IEEE TRANSACTIONS ON MICROWAVE THEORY AND TECHNIQUES, Bd. 41, Nr. 12, 1.Dezember 1993, Seiten 2147-2155, XP000426129 MULLER G ET AL: "DESIGN OF A LOW LOSS SAW REFLECTOR FILTER WITH EXTREMELY WIDE BANDWIDTH FOR MOBILE COMMUNICATION SYSTEMS"

## Beschreibung

Die vorliegende Erfindung betrifft ein mit akustischen Oberflächenwellen arbeitendes Filter - OFW-Filter - nach dem Oberbegriff des Patentanspruchs 1.

Bei OFW-Filtern können sehr kleine Eingangsimpedanzen oft nur durch elektrische Parallelschaltung mehrerer akustischer Spuren erreicht werden.

Der vorliegenden Erfindung liegt die Aufgabe zugrunde, ein OFW-Filter mit kleiner Eingangsimpedanz und großer Ausgangsimpedanz anzugeben.

Diese Aufgabe wird bei einem OFW-Filter der eingangs genannten Art erfindungsgemäß durch das Merkmal des kennzeichnenden Teils des Patentanspruchs 1 gelöst.

Weiterbildungen der Erfindung sind Gegenstand von Unteransprüchen.

Die Erfindung wird nachfolgend anhand eines Ausführungsbeispiels gemäß den Figuren der Zeichnung näher erläutert. Es zeigt:
- Figur 1: eine schematische Darstellung eines OFW-Filters mit zwei akustischen Spuren; und
- Figur 2: jeweils ein elektrisches Ersatzschaltbild der Eingangsseite bzw. Ausgangsseite des Filters nach Figur 1.

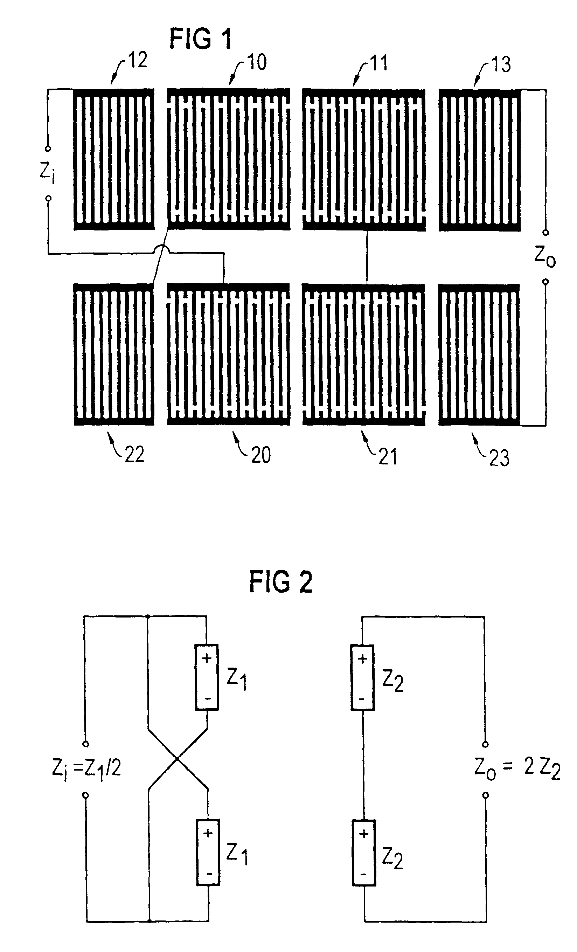

Gemäß Figur 1 ist ein OFW-Filter mit zwei akustischen Spuren vorgesehen, in denen jeweils ein Eingangsinterdigitalwandler 10 bzw. 20, ein Ausgangsinterdigitalwandler 11 bzw. 21 sowie jeweils zwei Endreflektoren 12, 13 bzw. 22, 23 auf voneinander abgewandten Seiten der Interdigitalwandler vorhanden sind. Wie weiterhin aus Figur 1 zu ersehen ist, sind erfindungsgemäß die Komponenten auf der Eingangsseite, d. h. die Interdigitalwandler 10, 20 und die Endreflektoren 12, 22 elektrisch parallel geschaltet, während die Komponenten auf der Ausgangsseite, d. h. die Interdigitalwandler 11, 21 und die Endreflektoren 13, 23 elektrisch in Reihe geschaltet sind. Die Eingangsimpedanz ist dabei mit Zᵢ und die Ausgangsimpedanz mit Zₒ bezeichnet.

Gemäß dem elektrischen Ersatzschaltbild auf der linken Seite von Figur 2 sind elektrische Impedanzen auf der Eingangsseite nach Figur 1, die mit Z₁ bezeichnet sind, elektrisch parallel geschaltet. Entsprechend sind gemäß dem elektrischen Ersatzschaltbild auf der rechten Seite von Figur 2 elektrische Impedanzen auf der Ausgangsseite, die mit Z₂ sind, elektrisch in Reihe geschaltet.

Durch eine derartige Verschaltung wird die Eingangsimpedanz Zᵢ gegenüber der Einzelspur halbiert, d. h. es ist Zᵢ = Z_{1/2}, während die Ausgangsimpedanz Z₀ gegenüber der Einzelspur verdoppelt wird, d. h. es ist Z₀ = 2 Z₂.

Die Erfindung ist nicht auf Ausführungsformen von OFW-Filtern mit zwei akustischen Spuren beschränkt. Entsprechende Verhältnisse ergeben sich auch bei OFW-Filtern mit mehr als zwei akustischen Spuren.

Weiterhin gilt die Erfindung auch für Filterausführungsformen mit anderen Komponentenkombinationen in den akustischen Spuren, beispielsweise auch für Ausführungsformen ohne Reflektoren.

## Patentansprüche

1. Mit akustischen Oberflächenwellen arbeitendes Filter-OFW-Filter - mit wenigstens zwei akustischen Spuren (10 bis 13 bzw. 20 bis 23),
**dadurch gekennzeichnet**,
daß die akustischen Spuren (10 bis 13 bzw. 20 bis 23) identisch ausgebildet sind, eingangsseitig elektrisch parallel und ausgangsseitig elektrisch in Reihe geschaltet sind, wobei die Eingangsimpedanz gegenüber einer einzelnen akustischen Spur reduziert ist.

2. OFW-Filter nach Anspruch 1,
**gekennzeichnet durch**
wenigstens einen Eingangsinterdigitalwandler (10 bzw. 20) einen Ausgangsinterdigitalwandler (11 bzw. 21) und jeweils einen auf voneinander abgewandten Seiten der Interdigitalwandler (10, 20 bzw. 11, 21) angeordneten Endreflektor (12, 13 bzw. 22, 23) in jeweils einer akustischen Spur.

## Claims

1. Filter operating with surface acoustic waves - SAW filter - having at least two acoustic tracks (10 to 13 and 20 to 23), characterized in that the acoustic tracks (10 to 13 and 20 to 23) are of identical design, are electrically connected in parallel on the input side and are electrically connected in series on the output side, the input impedance being reduced in comparison with that of a single acoustic track.

2. SAW filter according to Claim 1, characterized by at least one input interdigital converter (10 or 20), an output interdigital converter (11 or 21) an in each case one end reflector (12, 13 or 22, 23) (which end reflectors are arranged on mutually averted sides of the interdigital converters (10, 20 and 11, 21)) in each case one acoustic track.

## Revendications

1. Filtre travaillant avec des ondes de surface acoustiques - filtre OFW - comprenant au moins deux pistes acoustiques (10 à 13 ou 20 à 23 respectivement) ,
caractérisé
en ce que les pistes acoustiques (10 à 13 ou 20 à 23 respectivement) sont de configuration identique, sont connectées électriquement en parallèle sur le côté d'entrée et électriquement en série sur le côté de sortie, l'impédance d'entrée étant réduite comparativement à une piste acoustique élémentaire.

2. Filtre OFW selon la revendication 1,
caractérisé
par au moins un transducteur interdigital d'entrée (10 ou 20 respectivement), un transducteur interdigital de sortie (11 ou 21 respectivement), et des réflecteurs terminaux (12, 13 ou 22, 23 respectivement) disposés sur des côtés mutuellement opposés des convertisseurs en dents de peigne (10, 20 ou 11, 21 respectivement) dans chaque piste acoustique.
